# EUROPÄISCHE PATENTSCHRIFT

(11) **EP 1 565 935 B1**
(45) Veröffentlichungstag und Bekanntmachung des Hinweises auf die Patenterteilung: **17.06.2009**
(21) Anmeldenummer: 03788822.9
(22) Anmeldetag: 24.11.2003
(51) Int. Cl.: H01L 21/66, C23C 14/54

(54) **VERFAHREN ZUR HERSTELLUNG EINER CHALKOGENID-HALBLEITERSCHICHT MIT OPTISCHER IN-SITU-PROZESSKONTROLLE UND VORRICHTUNG ZUR VERFAHRENSDURCHFÜHRUNG**
METHOD FOR PRODUCING A CHALCOGENIDE SEMICONDUCTIVE LAYER WITH IN-SITU OPTICAL PROCESS CONTROL AND DEVICE FOR CARRYING OUT SAID METHOD
PROCEDE POUR PRODUIRE UNE COUCHE SEMI-CONDUCTRICE EN CHALCOGENURE AVEC CONTROLE OPTIQUE IN-SITU DU PROCEDE ET DISPOSITIF POUR EXECUTER CE PROCEDE

(30) Priorität: 30.11.2002 DE 10256909
(43) Veröffentlichungstag der Anmeldung: 24.08.2005
(73) Patentinhaber: Helmholtz-Zentrum Berlin für Materialien und Energie GmbH, 14109 Berlin (DE)
(72) Erfinder: SCHEER, Roland, 10119 Berlin (DE); NEISSER, Axel, D-10439 (DE)
(74) Vertreter: Rudolph, Margit
(86) Internationale Anmeldenummer: PCT/DE2003/003891
(87) Internationale Veröffentlichungsnummer: WO 2004/051734

(56) Entgegenhaltungen:
- WO-A-02/084729
- US-A- 3 853 093
- US-A1- 2002 068 126

## Beschreibung

Die Erfindung bezieht sich auf ein Verfahren zur Herstellung einer Chalkogenid-Halbleiterschicht des Elementtyps ABC₂ mit einer optischen in-situ-Prozesskontrolle, bei der während der Schichtherstellung die aktuelle Schichtoberfläche mit einem kohärenten Lichtstrahl bestrahlt und das diffus rückgestreute Licht detektiert und markanten Punkten im Prozessverlauf zugeordnet wird, wobei auftretende Abweichungen bei der Zuordnung durch Veränderung von Prozessparametern ausgeregelt werden, und auf eine Vorrichtung zur Durchführung des Verfahrens.

Ein derartiges Verfahren ist aus der DE 101 19 463 A1 bekannt. Die Prozesskontrolle in diesem Verfahren basiert auf der Detektion von Veränderungen in den Mikrorauigkeiten der Oberfläche sowie der optoelektronischen Eigenschaften der aktuellen Halbleiterschicht mithilfe von kohärentem Licht, insbesondere Laserlicht. Diese Veränderungen treten charakteristisch in Abhängigkeit von der aktuellen Struktur auf und zeigen insbesondere bei Phasenübergängen besonders deutliche Ausprägungen. Diese sind erkennbar durch stark veränderliche diffuse Rückstreuungswerte des eingestrahlten Laserlichts. Somit können markante Punkte im zeitlichen Verlauf des detektierten Streusignals markanten Punkten im Herstellungsprozess zugeordnet werden. Eine Erfassung des genauen Zeitpunktes bekannter Phasenübergänge und Änderungen in der Oberflächenmorphologie während des Schichtenwachstums ist möglich. Es kann daher ausgehend von der Kenntnis der Schichtmorphologie und der Änderung der Phasen und Phasenausscheidungen während des Chalkogenisierungsprozesses und dem zeitlichen Verlauf des detektierten Streulichtverlaufs eine gezielte in-situ-Beeinflussung des Prozesses erfolgen. Dieses bekannte Verfahren ist jedoch nur für die Prozesskontrolle ortsfester Substrate geeignet. Es findet ausschließlich eine zeitliche Zuordnung der detektierten Streuwerte zu den charakteristischen Punkten des Schichtenwachstums statt.

Streuprozesse von Licht an Oberflächen werden seit Längerem genutzt, um Schichtwachstum und Oberflächenmodifikationen von dünnen Schichten zu untersuchen. Beispielsweise ist aus der US-PS 5.725.671 ein Verfahren bzw. eine Vorrichtung zur Herstellung einer A^{I}B^{III}C^{VI}₂-Chalkopyrit-Dünnschicht (die römischen Zahlen bezeichnen die Elementgruppen) bekannt, die unter anderem ein System zur Überwachung und Darstellung einer physikalischen Größe der aktuell entstehenden Schicht in Abhängigkeit von der Zeit enthält. In der ersten Phase des Prozesses werden die Elemente A', B^{III}und C^{VI} auf ein Substrat aufgebracht, wobei das Element A im Überschuss angeboten wird. In der zweiten Phase wird der Anteil des Elements A^{I} in der Gasphase so verringert, dass das Element B im Überschuss vorhanden ist. Während des Prozesses wird u.a. die Chalkopyritschicht mit Infrarot-Licht bestrahlt und das von der Oberfläche dieser Schicht reflektierte Licht in Abhängigkeit von der Zeit gemessen. Als Endpunkt des Herstellungsprozesses wird ein Zeitpunkt angegeben, der 5 min bis 15 min nach der letzten abrupten Änderung des gemessenen Signals liegt. Es ist jedoch mit dieser bekannten Methode weder möglich, den Endpunkt des Herstellungsprozesses direkt aus der Signatur des gemessenen Lichts abzuleiten, noch ortsaufgelöste Messungen durchzuführen. Eine vollständige Prozesskontrolle ist somit nicht möglich.

Insbesondere können mit den genannten Verfahren aufgrund der fehlenden Ortsauflösung keine in-situ-Prozesskontrollen bei einem bewegten Substrat durchgeführt werden. In der DE 198 40 197 A1 wird ein ex-situ-Verfahren zur Prozesskontrolle mittels Ramanstreuung bei der Herstellung von monokristallinem Halbleitermaterial (Siliziumwafertechnik) beschrieben. Bei diesem Verfahren kann auch ein Scanmodus durchgeführt werden, mit dem größere Probenbereiche unter Ermittlung der Homogenität von Material und Prozess schnell charakterisiert werden können. Dazu wird das zu untersuchende monokristalline Halbleitermaterial nach seiner Fertigstellung mittels einer speziellen Halte- und Transportvorrichtung in eine für die Untersuchung geeignete Position überführt. Mit einer Scanvorrichtung wird dann die zu untersuchende Probe während der Messung gezielt bewegt. Es wird jedoch über den gesamten Probenbereich aus den Ergebnissen der Ramanstreuung ein Mittelwert für die Kristall-Homogenität der Probe zu einem einzigen Zeitpunkt erzeugt, anhand derer über die Qualität der erzeugten Probe entschieden werden kann. Trotz seines möglichen Scanmodus ist dieses bekannte Verfahren, das als ex-situ-Verfahren jeweils nach einer Schichtherstellung angewendet wird, jedoch nicht in der Lage, ortsaufgelöste Messwerte für bewegte Substrate zur Verfügung zu stellen, aus denen charakteristische Aussagen über den aktuellen Prozessverlauf abgeleitet werden können.

Für die Herstellung temärer und quaternärer polykristalliner Halbleiterschichten ist jedoch eine in-situ-Prozesskontrolle von außerordentlicher Bedeutung. Nur so kann regelnd in den Herstellungsprozess eingegriffen und die für viele Anwendungen geforderte kristalline Qualität erreicht werden. Eines der Hauptanwendungsgebiete solcher Halbleiterschichten sind Dünnschichtsolarzellen auf Basis von Chalkogenid-Halbleiterschichten, insbesondere Cu-Chalkopyritschichten. Dünnschichtsolarzellen stellen eine effiziente und kostengünstige Alternative zu herkömmlichen Technologien in der Photovoltaik dar. Mögliche Herstellungsverfahren für Chalkogenid-Halbleiterschichten des Typs A^{I}B^{III}C^{VI}₂ umfassen u.a. die Koverdampfung, Chalkogenisierung von Vorläuferschichten, Elektrodeposition oder Spraypyrolyse. In Bezug auf die Anwendung in Dünnschichtsolarzellen werden die höchsten Energieumwandlungswirkungsgrade mit Koverdampfungstechniken erreicht. Allerdings nur bei einer entsprechend effizienten Prozesskontrolle. Dem Stand der Technik nach allgemein bekannt ist die Herstellung von polykristallinen Chalkogenid-Halbleiterschichten durch Abscheidung aus der Dampfphase (engl. "physical vapour deposition" - PVD). Die PVD ist eine Standardtechnik der Dünnfilmtechnologie. Wird mehr als ein Element gleichzeitig abgeschieden, so spricht man von "Koverdampfung". Im Hinblick auf z.B. photovoltaische Anwendungen, sind sequenzielle Koverdampfungsprozesse besonders interessant, bei denen sich die stöchiometrische Zusammensetzung des Films im Verlaufe der Schichtabscheidung ein oder mehrere Male von einer Element-A^{I}-reichen zu einer Element-A^{I}-armen (oder umgekehrt) Komposition verändert. Berichte über verschiedene sequenzielle Rezepte sind aus der Literatur allgemein bekannt. Die Prozesse bestehen aus ein oder mehreren (in der Regel drei) Depositionsphase, in denen die benötigten Elemente A', B^{III} (wobei auch zwei Elemente aus der dritten Hauptgruppe B1^{III} und B2^{III} als Verbindung eingesetzt werden können) und C^{VI} simultan und/oder sequenziell auf dem Substrat abgeschieden werden. Gemeinsam ist allen Rezepten, dass die zeitliche Länge einer oder mehrerer Phasen bestimmt wird durch charakteristische Wechsel in der stöchiometrischen Zusammensetzung der Chalkopyrit-Dünnschicht zwischen Element-A'-armen und -reichen Schichtaufbauten. Die möglichst genaue Erkennung dieser charakteristischen Punkte durch geeignete Überwachungsmittel (Prozesskontrolle) ist eine unerlässliche Voraussetzung für die effiziente Abscheidung eines Chalkopyritfilms mit einer gewünschten Komposition im sequenziellen Koverdampfungsverfahren. Weiterhin ist es allgemein bekannt, Halbleiterschichten in einem kontinuierlichen Betrieb auf einem bewegten Substrat besonders effizient herstellen zu können. Das Substrat wird dabei im Durchlaufbetrieb oder Rolle-zu-Rolle durch eine oder mehrere Prozesskammem geführt, in denen die einzelnen Abscheidungsphasen stattfinden. Auf dem Substrat findet somit ortsabhängig ein kontinuierlicher Schichtaufbau statt.

Ausgehend von dem oben beschriebenen Verfahren der gattungsgemäßen Art nach der DE 101 19 463 A1, von dem die Erfindung als nächstliegendem Stand der Technik ausgeht, und vor dem Hintergrund der besonders effizienten Herstellung qualitativ hochwertiger Halbleiterschichten im kontinuierlich betriebenen Koverdampfungsprozess ist es daher die **Aufgabe** für die Erfindung, das bekannte Verfahren zur Herstellung einer Chalkogenid-Halbleiterschicht mit optischer in-situ-Prozesskontrolle so weiterzubilden, dass auch ein Herstellungsprozess nach dem Koverdampfungsprinzip auf einem kontinuierlich fortbewegten Substrat über eine in-situ-Kontrolle der zeitlichen Endpunkte der einzelnen Phasen des Wachstums in seinem Ablauf geregelt werden kann. Dabei soll das erfindungsgemäße Verfahren einfach in seinem Ablauf und damit kostengünstig in seiner Realisierung sein. Es soll weitgehend unempfindlich gegen Fehlereinflüsse sein und zuverlässige, reproduzierbare Ergebnisse liefern, die eine optimale Prozesskontrolle ermöglichen.

Die **Lösung** für diese Aufgabe besteht erfindungsgemäß in einem Verfahren zur Herstellung einer Chalkogenid-Halbleiterschicht des Elementtyps ABC₂ in einem ein- oder mehrphasigen sequenziellen Koverdampfungsprozess, bei dem die zeitlichen Längen der einzelnen Depositionsphasen im Schichtenwachstum durch charakteristische Wechsel in der stöchiometrischen Schichtzusammensetzung zwischen reicher und armer Element-A-Beteiligung bestimmt werden, mit einer kontinuierlichen Beschichtung eines bewegten Substrates entlang einer Depositionsstrecke und mit einer optischen in-situ-Prozesskontrolle, bei der
- während der Schichtherstellung zyklisch ein kohärenter Lichtstrahl über den Depositionsbereich des bewegten Substrats mit einer Abtastgeschwindigkeit, die deutlich größer als die Fortschrittsgeschwindigkeit des Substrats ist, geführt wird,
- das diffus an der aktuellen Schichtoberfläche rückgestreute Licht als Funktion des Ortes auf dem bewegten Substrat gemessen und als örtliches Streulichtprofil entlang der Depositionsstrecke für das Zeitintervall At, in dem der kohärente Lichtstrahl einmal den Depositionsbereich des Substrats abtastet, dargestellt wird,
- markante Punkte im örtlichen Streulichtprofil den charakteristischen Wechseln in der stöchiometrischen Schichtzusammensetzung zugeordnet werden,
- die gemessenen markanten Punkte im aktuellen Streulichtprofil mit den entsprechenden Punkten in einem für die Herstellung vorgegebenen Referenz-Streulichtprofil verglichen werden und
- bei Auftreten einer örtlichen Abweichung der einander entsprechenden Punkte diese durch Änderung der Abscheiderate oder Fortschrittsgeschwindigkeit des bewegten Substrats in der Prozessführung ausgeregelt wird.

Der Abscheideprozess bei dem erfindungsgemäßen Verfahren basiert auf der sequenziellen Koverdampfung. Das Herstellungsprozess besteht im Wesentlichen aus zwei, drei oder mehr Herstellungsphasen. Diese erfolgen nacheinander, entweder räumlich getrennt in jeweiligen Prozesskammem oder innerhalb einer Kammer. Wesentlich ist die kontinuierliche Beschichtung eines bewegten Substrates entlang einer Depositionsstrecke. Die Aufdampfraten der einzelnen Verdampferquellen werden dabei so eingestellt, dass die stöchiometrische Zusammensetzung des auf einem nacheinander über die verschiedenen Verdampferquellen geführten Substrat abgeschiedenen Films sich während des Prozesses mehrmals von Element-A-arm zu Element-A-reich und auch umgekehrt verändert. Die finale Zusammensetzung des Chalkopyritfilms liegt in der Regel nahe der stöchiometrischen Zusammensetzung von beispielsweise einer A^{I}(B1^{III}B2^{III})C^{VI}₂ Verbindung und ist bevorzugt leicht Element-A^{I}-arm. Ein Beispiel für eine bevorzugt herzustellende Chalkogenidschicht mit hervorragenden Eigenschaften ist eine CulnSe₂-Schicht. Die Erfindung bezieht sich jedoch gleichermaßen auch auf Prozesse, bei denen das Element In durch Ga oder Kombinationen von In₁₋ₓGaₓ ersetzt wird, das Element Se durch S oder Kombination von Se₁₋ₓSₓ, und/oder das Element Cu durch Ag oder Al oder entsprechende Kombinationen ersetzt wird. Die Erfindung umfasst alle Prozesse, bei denen die Elemente Cu, In, Ga, Se, S usw. sequenziell und/oder simultan verdampft werden. Es ist allgemein bekannt, dass vergleichbare Ergebnisse auch durch Verdampfen binärer Verbindungen der oben genannten Elemente erreicht werden.

Wesentliches Prinzip für die in-situ-Prozesskontrolle bei der Erfindung ist die Einstrahlung von kohärentem Licht auf die aktuelle Schichtoberfläche und die Detektion des diffus gestreuten Rücklichts in Abhängigkeit vom Ort der Beleuchtung des bewegten Substrats. Damit kann mit dem erfindungsgemäßen Verfahren ein ortsabhängiges Streulichtprofil über den gesamten Depositionsbereich mit einer sehr hohen Ortsauflösung erstellt werden. Markante Punkte in diesem Streulichtprofil werden dabei charakteristischen Punkten im Abscheidungsprozess, insbesondere Phasenübergängen und - veränderungen, zugeordnet. Bei Abweichungen des aktuellen Streulichtprofils von einem vorgegebenen Referenz-Streulichtprofil wird der Abscheidungsprozess an den Abweichungsstellen kompensierend ausgeregelt, sodass für die herzustellende Chalkogenidschicht eine gleichbleibend hohe Güte garantiert werden kann. Die optische Prozesskontrolle des erfindungsgemäßen Verfahrens erlaubt eine in-situ Kontrolle charakteristischer Punkte des Abscheideprozesses, die ohne Prozesskontrolle nicht erkennbar sind. Dadurch ist es möglich, die Abscheideraten der einzelnen Prozessschritte und/oder die Fortschrittsgeschwindigkeit des bewegten Substrates so zu steuern, dass ein gewünschtes Profil der Abscheidung entlang der Depositionsstrecke eingestellt werden kann.

Im Gegensatz zu dem bekannten Verfahren mit einem Scanmodus, mit dem zu einem einzelnen Zeitpunkt t eine gemittelte Aussage über einen einzigen Schichtzustand getroffen wird, kann mit dem erfindungsgemäßen Verfahren eine zeitlich und örtlich vorausschauende Erfassung über alle möglichen Schichtzustände entlang der gesamten Depositionsstrecke für jedes Zeitintervall des Depositionsprozesses, in dem der Lichtstrahl den Depositionsbereich einmal abtastet, erfolgen. Der messauflösende Parameter, dem die einzelnen detektierten Rückstreuwerte zugeordnet werden, ist hierbei der Ort des Auftreffens des kohärenten Lichtstrahls auf das fortbewegte Substrat. So kann ein Streulichtprofil beispielsweise durch Auftragen der detektierten Rückstreuintensität über dem mit dem Abstand der kohärenten, gegenüber dem Depositionsbeginn positionierten Lichtquelle zum Substrat multiplizierten Tangens des aktuellen Auslenkwinkels des Lichtstrahls von der Senkrechten aus erstellt werden. Dies entspricht einer kontinuierlich anwachsenden, keilförmigen Halbleiterschichtstärke entlang der Depositionsstrecke. Um eine Aussage über das aktuelle Streulichtprofil zu erhalten, die bei Abweichungen ein rechtzeitiges Eingreifen in den Prozess ermöglicht, ist es wichtig, den Depositionsbereich wesentlich schneller abzutasten als sich das Substrat fortbewegt. Durch die zyklische Wiederholung des Abtastvorganges entstehen so in bestimmten Zeitabständen, die von der Abtastgeschwindigkeit und der Messwertaufnahme und -verarbeitung festgelegt sind, immer aktuelle Streulichtprofile. Dadurch kann auch die Wirksamkeit von abweichungsausregelnden Maßnahmen überprüft werden. Die Zyklusfrequenz und damit die Abtastgeschwindigkeit ist dabei abhängig von der geforderten Wiederholrate bei der Aktualisierung des Streulichtprofils. Ein bedeutender Vorteil des erfindungsgemäßen Verfahrens, das bevorzugt bei der Herstellung von Chalkopyrit-Dünnschicht-Solarzellen Anwendung findet, besteht also darin, dass die Methode die genaue und verzögerungsarme Steuerung der Abscheidung auf einem bewegten Substrat erlaubt. Damit kann eine effiziente in-situ-Prozesskontrolle in ein besonders effizientes Herstellungsverfahren integriert werden. Alle kritischen Punkte des Herstellungsprozess lassen sich direkt aus der örtlichen Signatur des gemessenen Rückstreusignals ableiten. Dadurch wird eine vollständige und zuverlässige Steuerung aller Stufen des Abscheideprozess auf einem bewegten Substrat möglich.

Vorteilhafte Weiterbildungen des erfindungsgemäßen Verfahrens zur Herstellung einer Chalkogenid-Halbleiterschicht des Elementtyps ABC₂ mit einer optischen in-situ-Prozesskontrolle sind den Unteransprüchen zu entnehmen. Eine bevorzugte Vorrichtung zu Durchführung insbesondere des erfindungsgemäßen Verfahrens ist charakterisiert durch zumindest eine Abscheidekammer mit einem kontinuierlich entlang der Depositionsstrecke fortbewegbaren Substrathalter, dessen Rückseite von einem Substratheizer erwärmt wird, mit zumindest einer intermittierend und einer dauerhaft betreibbaren Verdampferquelle und mit einer außerhalb der Abscheidekammer angeordneten optischen Prozesskontrolle mit einer kohärenten Lichtquelle, deren emittierter Lichtstrahl zyklisch und kontinuierlich mit einer Abtastgeschwindigkeit, die deutlich größer als die Fortschrittsgeschwindigkeit des Substrathalters ist, über den Depositionsbereich führbar ist, und mit einem Detektor, der die Rückstreuwerte in Abhängigkeit vom Messort innerhalb der Depositionsstrecke detektiert und einer Auswertungseinheit zuführt, die die detektierten Rückstreuwerte vorgegebenen Referenzwerten zuordnet und für eine Ausregelung von Regelabweichungen durch Veränderung von Prozessparametern sorgt. Wesentliches Merkmal der beanspruchten Vorrichtung ist die in-situ-Prozesskontrolle, die aus einer dem Substrat gezielt nachführbaren kohärenten Lichtquelle und einem Detektor, der die Rückstreuwerte in Abhängigkeit von dem Auftreffpunkt des kohärenten Lichtstrahls auf das bewegte Substrat detektiert und in ein örtliches Streulichtprofil überführt. Damit ist die beanspruchte Vorrichtung die erste ihrer Art, die eine hochgenau ortsaufgelöste Analyse einer herzustellenden Chalkogenidschicht auf einem bewegten Substrat ermöglicht. Die Dimensionierung der Vorrichtung ergibt sich aus einer Optimierung verschiedener technologischer Anforderungen. Hierzu zählen beispielsweise die Anzahl der verfügbaren Verdampferquellen pro Prozessstufe, aus der sich der Bereich homogener Beschichtung entlang der Depositionsstrecke ergibt, die Fortschntigeschwindigkeit des Substrats oder der erforderliche Substratdurchsatz. Eine bezüglich dieser Parameter bevorzugte Ausführungsform und weitere Ausführungsformen sind ebenfalls den nachgeordneten Unteransprüchen zu entnehmen

Zur Vermeidung von Wiederholungen werden die vorteilhaften Weiterbildungen des erfindungsgemäßen Verfahrens und die bevorzugte Vorrichtung im Folgenden im Zusammenhang mit den **schematischen Figuren,** die insbesondere dem weiteren Verständnis der Erfindung dienen, beispielhaft näher erläutert. Dabei zeigt :
- **Figur 1**: ein örtliches Streulichtprofil,
- **Figur 2**: ein Diagramm zur Stöchiometrie der herzustellenden Schicht,
- **Figur 3**: ein Diagramm zum Fluss der Verdampferquellen,
- **Figur 4**: eine Aufdampfanlage mit einer Prozesskammer und
- **Figur 5**: eine Aufdampfanlage mit drei Prozesskammern.

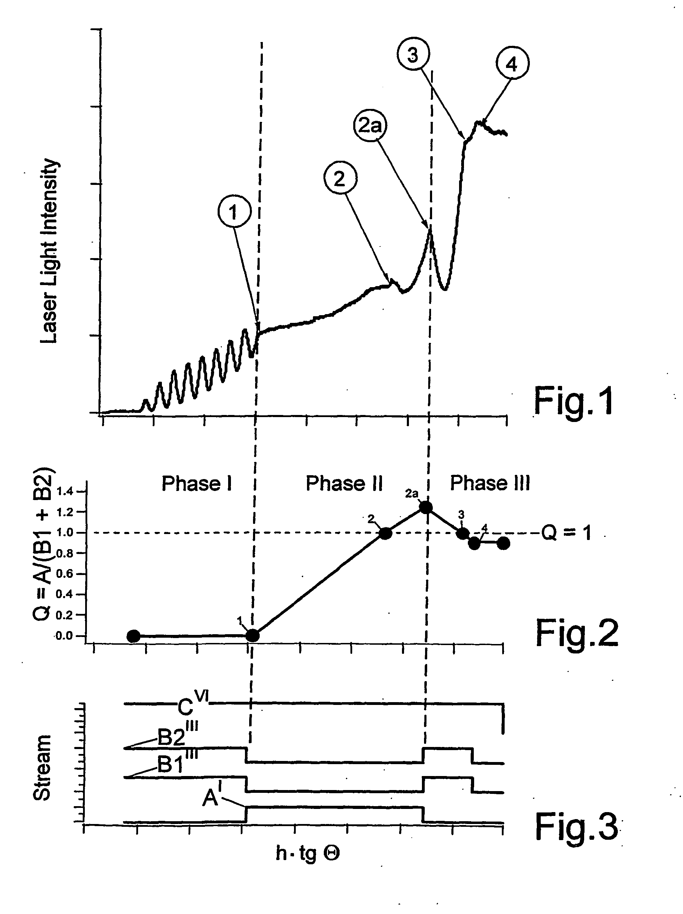

Die **Figuren 1, 2 und 3** zeigen alle Diagramme mit einer Auftragung über die Depositionsstrecke. Sie können daher im direkten Zusammenhang miteinander betrachtet werden. Die Verfolgung senkrechter Linien ergibt eine Zuordnung der einzelnen Parameter zueinander und zum Depositionsort. Dabei ist dieser in den Diagrammen definiert durch das Produkt **h · tg** Θ mit Θ = aktueller Auslenkungswinkel des kohärenten Lichtstrahls und **h** = Abstand der Licht quelle zur Schichtoberfläche.

Die **Figur 1** zeigt ein örtliches Streulichtprofil für einen beispielhaft ausgewählten Prozess zur Herstellung einer Cu(Ga,In)Se₂-Schicht auf einer Metallfolie. Ist der Prozess in seiner Parametrierung optimal abgelaufen, handelt es sich um ein Referenz-Streulichtprofil, an das die aktuellen Streulichtprofile jeweils anzugleichen sind. Zum besseren Verständnis wird zunächst der ablaufende Prozess näher erläutert. Die Abscheidung findet in einer oder mehreren Abscheidekammer im Hochvakuum statt (p ≈ 1×10⁻³Pa). Das Substrat wird dabei auf eine Temperatur zwischen 300°C bis 600ºC aufgeheizt. Der Abscheideprozess nach dem Koverdampfungsverfahren umfasst drei Depositionsphasen: **Phase I :** Verdampfung von In-Ga-Se, **Phase II:** Verdampfung von Cu-Se und **Phase III:** Verdampfung von In-Ga-Se. Se wird dabei in allen drei Phasen im Überschuss angeboten. Das zu beschichtende Substrat durchläuft während der Abscheidung die Abscheidekammem (Durchlaufbetrieb oder Rolle-zu-Rolle). Als Substrat dient eine flexible Metallfolie, z.B. aus Titan. Es können aber auch temperaturbeständige Kunststofffolien verwendet werden oder Glassubstrate. Auf das Substrat wird in der Regel zunächst eine etwa 1 µm dicke Molybdänschicht aufgebracht. Die Molybdänschicht dient als Diffusionsbarriere für Substratverunreinigungen und als elektrischer Rückkontakt für Solarzellenstrukturen auf isolierenden Substraten. Weiterhin ist allgemein bekannt, dass die Zugabe von Natrium, beispielsweise durch Aufbringen einer Natrium-haltigen Vorläuferschicht (z.B. Natriumfluorid), durch Koverdampfen von Natrium während des Abscheideprozesses oder durch Ausdiffusion aus einem Natrium-haltigen Substrat, die Qualität der hergestellten Chalkogenidschicht bezüglich ihrer halbleitenden Eigenschaften noch verbessert.

In der **Phase I** bildet sich eine Vorläuferschicht der Stöchiometrie (In, Ga)₂Se₃ auf dem bewegten Substrat. Dabei kann die (In, Ga)₂Se₃-Schicht sowohl durch Verdampfen der einzelnen Elemente In, Ga und Se abgeschieden werden als auch durch Verdampfen der entsprechenden binären Verbindungen In₂Se₃ oder InSe und Ga₂Se₃ oder GaSe oder durch Verdampfen von (In, Ga)₂Se₃. Die Substrattemperatur beträgt 350°-C. In der **Phase II** wird die Substrattemperatur auf 550°-C erhöht und die Vorläuferschicht durch Eindiffusion von Kupfer in eine Schicht mit Chalkopyritstruktur umgewandelt. Nach Durchlaufen des markanten stöchiometrischen Punkts **Q = A^{I}/(B1^{III} + B2^{III})=** [Cu]/([In]+ [Ga]) = 1 bis in den Bereich 1 < [Cu]/([In]+[Ga]) < 1,3 bilden sich defektfreie Chalkopyrit-Kristallkörner (Dimension 1 µm - 3 µm) sowie eine zusätzliche Cu-Se-Binärphase. Durch diese zusätzliche chemische Verbindung, die auf der aktuellen Schichtoberfläche segregiert, wird eine markante Änderung der Oberflächenrauigkeit hervorgerufen, die zuverlässig detektierbar ist (markanter Punkt 2, vergleiche Figur 1). In der dritten **Phase III** wird die Gesamtstöchiometrie des Films wieder in den Bereich **Q** = [Cu]/([In]+[Ga]) < 1 überführt. Dieser bevorzugte Bereich wird beispielsweise zur Herstellung hocheffizienter Dünnfilmsolarzellen benötigt.

Das örtliche Streulichtprofil auf dem Substrat gemäß **Figur 1** zeigt schematisch den Verlauf der örtlich detektierten Rückstreuwerte aufgrund der im Prozessverlauf auftretenden veränderten stöchiometrischen Verhältnisse bzw. der damit verbundenen Änderungen der Mikrorauigkeit der aktuellen Schichtoberfläche ("Laser Light Intensity" über dem Detektionsort **h · tg** Θ mit Θ = aktueller Auslenkungswinkel des kohärenten Lichtstrahls und **h** = Abstand der Lichtquelle zur Schichtoberfläche). Deutlich ist die **Phase I** bis zum **Punkt 1**, die **Phase II** bis zum **Punkt 2a** und die **Phase III** bis zum **Punkt 3** bzw. dem Prozessende zu erkennen. Dabei sei an dieser Stelle darauf hingewiesen, dass es sich hierbei um die einzelnen Depositionsphasen des Prozesses handelt, die nicht unbedingt mit der chemischen Phasenbildung der Schichtbildung übereinstimmen. In der **Figur 2** ist die stöchiometrische Zusammensetzung der herzustellenden Schicht **Q = A/(B1 + B2)** als Funktion des Depositionsortes dargestellt, für das gewählte Beispiel also das [Cu]/([In]+[Ga]) Verhältnis. Markant ist das Gleichverhältnis zwischen den Anteilen von A^{I} und B1^{II}+B2^{III}bei **Q** =1. Diese Linie wird im Prozess zweimal durchlaufen. Bei ersten Durchqueren werden die Verdampferquellen B1^{III}und B2^{III} erst dann abgestellt, wenn der übersättigte **Punkt 2a** erreicht ist. Dieser soll bei einem Wert Q unterhalb von 1,3 liegen und kann in der Prozessführung beispielsweise durch eine Verlängerung der Depositionszeit - bezogen auf die Depositionsphase II bis zum markanten Punkt 2 - um 5 % bis 30 % erreicht werden. Für eine optimale Prozessführung ist es von besonderer Wichtigkeit zu wissen, wann der **Punkt 2** erreicht ist und damit am **Punkt 2a** die **Phase II** entsprechend beendet werden kann. Wichtig für eine möglichst hohe kristalline Qualität der herzustellenden Halbleiterschicht ist auch die kurzfristige Überschreitung der Linie Q=1, sodass sich die Binärphase bilden kann. In der **Phase III** wird die Verhältnis **Q** wieder auf ein Untersättigungsverhältnis gebracht. Dabei liegt der optimale **Punkt 4** bei einem Verhältnis **Q** ≈< 1. Bei Erreichen dieses markanten **Punktes 4** werden die Verdampferquelle B1^{III}und B2^{III} abgeschaltet und der Prozess darauffolgend durch Abschalten der während des Abscheidungsprozesses ständig aktivierten Verdampferquelle C^{VI} beendet. **Figur 3** zeigt schematisch den zugehörigen Fluss der einzelnen Verdampferquellen über der Depositionsstrecke. Dabei ist der Fluss als binäre "1" für eine aktivierte Verdampferquelle und der Fluss "0" für eine deaktivierte Verdampferquelle dargestellt. Die Aufdampfrate der einzelnen Verdampferquellen und/oder die Fortschrittsgeschwindigkeit des Substrates werden nun so gewählt, dass die markanten **Punkte 1, 2, 2a** und **3** im Streulichtprofil gemäß **Figur 1** mit den jeweiligen Punkten **1, 2, 2a** und **3** der Depositionsbereiche **DA** gemäß **Figur 2** in Abhängigkeit vom Fluss der Verdampferquellen gemäß **Figur 3** zusammenfallen. Die optische Prozesskontrolle des Verfahrens nach der Erfindung erlaubt bei Abweichungen der entsprechenden Punkte voneinander eine Korrektur dieser Parameter während des Prozesses und damit einen stabilen Depositionsprozess. Wichtig ist, dass in jedem aktuellen Streulichtprofil der markante **Punkt 2** mit **Q=1** zu erkennen ist und in Übereinstimmung mit dem markanten **Punkt 2** im Referenz-Streulichtprofil gebracht wird. Dieser **Punkt 2** ist ein durch die Prozessführung bei der Schichtbildung festlegbar. Somit kann er zuverlässig als "Eichpunkt" für die Prozessführung verwendet werden. Um diesen **Punkt 2** jedoch erkennen zu können, ist die in-situ-Prozesskontrolle nach der Erfindung erforderlich.

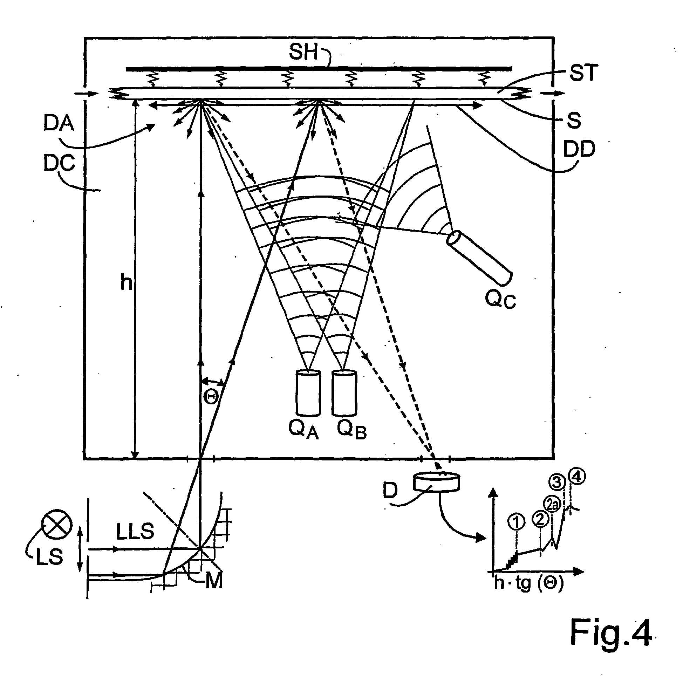

In der **Figur 4** ist eine Vorrichtung zur Durchführung des Verfahrens nach der Erfindung mit einer Abscheidekammer **DC** schematisch dargestellt. Die Abscheidung entlang einer Depositionsstrecke **DD** erfolgt im Koverdampfungsprozess auf einem mittels eines Substrathalters ST bewegten Substrat **S** in einem Depositionsbereich **DA.** Das Substrat **S** ist im dargestellten Beispiel auf einem Laufband angeordnet (Durchlaufbetrieb). Ein Betrieb von Rolle zu Rolle ist ebenfalls möglich. Hinter dem Substrat **S** ist ein Substratheizer **SH** angeordnet, mit dem das Substrat **S** auf Temperaturen zwischen 350°C und 500°C aufgeheizt werden kann. In der Abscheidekammer sind Verdampferquellen **Q_{A}** und **Q_{B},** wobei **Q_{B}** aus zwei Verdampferquellen **Q_{B1}** und **Q_{B2}** bestehen kann, angeordnet. Diese Verdampferquellen **Q_{A}** und **Q_{B}** werden diskontinuierlich betrieben. Dagegen bietet eine Verdampferquelle **Q_{C}** kontinuierlich das Element **C** während des ganzen Koverdampfungsprozesses im Überschuss an. Desweiteren kann die Abscheidekammer **DC** auch zusätzliche Verdampferquellen beispielsweise für die Bereitstellung von Na oder eine vorgeschaltete Depositionskammer aufweisen.

Außerhalb der Abscheidekammer **DC** ist als Teil der optischen in-situ-Prozesskontrolle eine kohärente Lichtquelle **LS,** beispielsweise eine Laserdiode, mit einem Abstand **h** zum Substrat **S** angeordnet (in den Figuren zur besseren Anschauung nicht maßstäblich dargestellt), deren kohärenter Lichtstrahl **LLS** dem bewegten Substrat **S** zyklisch und kontinuierlich nachführbar ist. Dabei ist die Nachführgeschwindigkeit des Laserstrahls **LLS** jedoch deutlich größer als die Fortschrittsgeschwindigkeit des bewegten Substrats **S**, sodass die sich aufbauende Chalkogenidschicht auf dem Substrat **S** ständig im Abtastintervall abgetastet werden kann. Das von der aktuellen Oberfläche diffus rückgestreute Laserlicht wird in seiner Intensität von einem Detektor **D** ortsabhängig unter einem detektorabhängigen Raumwinkel gemessen und in einem aktuellen Streulichtprofil über der Depositionsstrecke **DD** dargestellt. In einer in der **Figur 4** nicht weiter dargestellten Auswertungseinheit werden dann markante Punkte des aktuellen Streulichtprofils mit einem vorgegebenen Referenz-Streulichtprofil des optimalen Abscheidungsvorganges (vergleiche **Figur 1****)** verglichen. Auftretende örtliche Abweichungen zwischen den einander entsprechenden Punkten in den einzelnen Depositionsphasen werden durch Änderung der Prozessparameter für die entsprechenden Phase ausgeregelt. Hierbei kann es sich insbesondere um eine Änderung der Abscheiderate (vergleiche **Figur 3****)** oder der Fortschrittsgeschwindigkeit des Substrates **S** handeln. Dabei wird darauf geachtet, dass sich die Änderungen für die abweichende Dep9sitionsphase nicht auf die anderen Depositionsphasen auswirkt. Insbesondere bei einer Änderung der Fortschrittsgeschwindigkeit müssen daher die Laufbänder zumindest in einem bestimmten Maße voneinander entkoppelt sein, beispielsweise durch eine Laufbandschleife zwischen den einzelnen Depositionsphasen. Eine Änderung der Quellentemperatur, die eine Änderung der Aufdampfraten der Quellen bzw. der Abscheideraten auf dem bewegten Substrat bewirkt, kann für jede Depositionsphase unabhängig so geregelt werden, dass das gewünschte Streulichtprofil gemäß dem Referenz-Streulichtprofil erzeugt wird.

In der **Figur 4** ist weiterhin eine mögliche Realisation für das Nachführen des kohärenten Lichtstrahls **LLS** in Relation zum bewegten Substrat **S** beispielhaft dargestellt. Andere Konstruktionen, die die gleichmäßige Fortbewegung des Lichtstrahls LLS ermöglichen, sind ebenfalls realisierbar. Bei der gezeigten Ausführungsform ist die kohärente Lichtquelle **LS** vertikal verschieblich und einem Hohlspiegel **M** gegenüberliegend angeordnet, der den emittierten Lichtstrahl **LLS** auf das Substrat S lenkt. Je nach Höheneinstellung der Lichtquelle **LS** ergibt sich somit ein anderer Einfallsort auf dem Substrat S, der von dem Detektor **D** registriert und dem jeweils gemessenen Rückstreuwert von diesem Ort zugeordnet wird. Als Messparameter kann dabei die Strecke auf dem Substrat **S** vom Depositionsbeginn, unter dem die Lichtquelle **LS** angeordnet ist, herangezogen werden, die aus dem Tangens des Auslenkungswinkels Θ des Lichtstrahls **LLS,** multipliziert mit dem Abstand h der Lichtquelle LS zum Substrat S, abgeleitet werden kann.

Die Dimensionierung der Vorrichtung ergibt sich aus einer Optimierung verschiedener technologischer Anforderung. Hierbei handelt es sich beispielsweise um die Anzahl der verfügbaren Verdampferquellen pro Depositionsphase, aus der sich der Bereich homogener Beschichtung entlang der Depositionsstrecke **DD** ergibt oder um den erforderlichen Substratdurchsatz, in den die Substratgeschwindigkeit eingeht. Mögliche Prozessparameter bei der Herstellung von Chalcogenid-Halbleiterschichten des Typs A^{I}B^{III}C^{VI}₂ und A^{I}(B1^{III}B2^{III})C^{VI}₂ mittels Koverdampfung im kontinuierlichen Betrieb sind:
- Länge der Depositionsstrecke für Depositionsphase I 0,5 m
- Länge der Depositionsstrecke für Depositionsphase II 0,5 m
- Länge der Depositionsstrecke für Depositionsphase III 0,125 m
- Fortschrittsgeschwindigkeit des Substrats 0,025 m/min
- Abtastgeschwindigkeit des Lasers 1.25 m/min
- Ortsauflösung 0,01 m
- Integrationszeit pro Messpunkt 0,48 s
- Substratdurchsatz 1,5 m/h

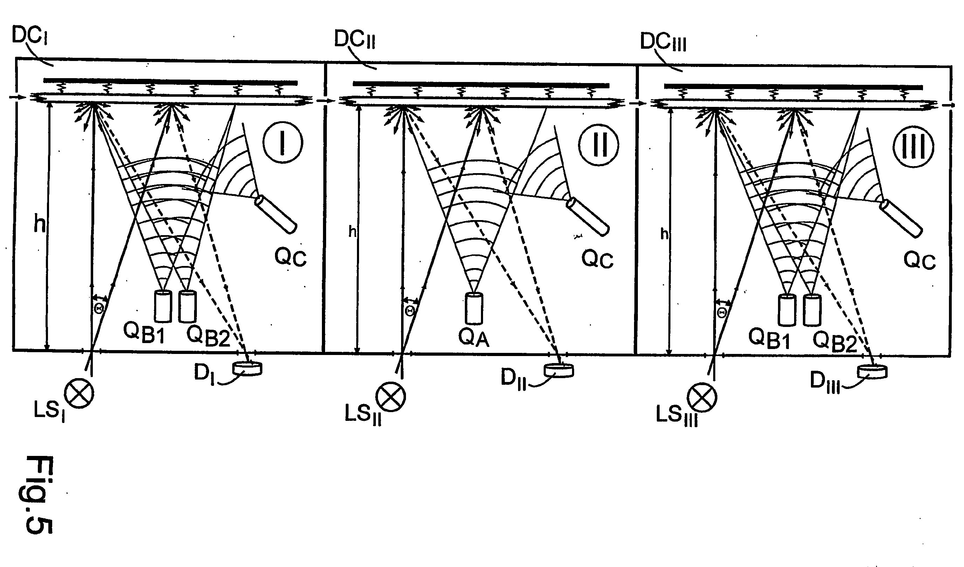

In der **Figur 5** ist eine Vorrichtung zur Umsetzung des Verfahrens nach der Erfindung dargestellt, wie sie häufig in der Praxis eingesetzt wird. Diese besteht aus drei Abscheidekammern **DC_{I} DC_{II}** und **DC_{III}** die jedoch alle in ihrem Aufbau der gemeinsamen Abscheidekammer DC gemäß Figur 4 entsprechen. Insbesondere verfügt jede Abscheidekammer **DC_{I} DC_{II}** und **DC_{III},** in der jeweils eine Depositionsphase **I, II** und **III** durchgeführt wird, über eine eigene optische in-situ-Prozesskontrolle mit einer kohärenten Lichtquelle **LS_{I}, LS_{II},LS_{III}** und einem Detektor **D_{I}, D_{II}, D_{III}.** Bei einer derartigen Dreikammer-Anordnung kann beispielsweise zwischen den Kammern die oben erwähnte Bandschleife zur Erzielung unterschiedlicher Fortschrittsgeschwindigkeiten in den einzelnen Kammern realisiert werden. Auch ist eine unabhängige Regelung der relevanten Prozessparameter zur Veränderung der Abscheideraten in den einzelnen Kammern problemlos möglich.

### Bezugszeichenliste

- **A^{I}**: Element der ersten Hauptgruppe
- **B^{III}, B1^{III}, B2^{III}**: Element der dritten Hauptgruppe
- **C^{VI}**: Element der sechsten Hauptgruppe
- **D**: Detektor
- **D_{I}, D_{II}, D_{III}**: Detektor Phase I, II, III
- **DA**: Depositionsbereich
- **DC**: Abscheidekammer
- **DC_{I}, DC_{II}, DC_{III}**: Abscheidekammer Phase I, II, III
- **DD**: Depositionsstrecke
- **h**: Abstand LS/S
- **LLS**: kohärenter Lichtstrahl
- **LS**: kohärente Lichtquelle
- **LS_{I}, LS_{II},LS_{III}**: kohärente Lichtquelle Phase I, II, III
- **M**: Hohlspiegel
- **Phase** I: erste Depositionsphase
- **Phase II**: zweite Depositionsphase
- **Phase III**: dritte Depositionsphase
- **Punkt 1**: markanter Punkt Ende Phase I
- **Punkt 2**: markanter Punkt Q = 1
- **Punkt 2a**: markanter Punkt Ende Phase II
- **Punkt 3**: markanter Punkt Q = 1
- **Punkt 4**: markanter Punkt mit optimalen Q ≈< 1
- **Q**: stöchiometrisches Verhältnis A^{I}/B^{III} bzw. A^{I}/(B1^{III} + B2^{III})
- **Q_{A}Q_{B},Q_{B1},Q_{B2},Q_{C}**: Verdampferquelle A, B, B1, B2, C
- **S**: Substrat
- **SH**: Substratheizer
- **ST**: Substrathalter
- Θ: Auslenkungswinkel LSS

## Patentansprüche

1. Verfahren zur Herstellung einer Chalkogenid-Halbleiterschicht des Elementtyps ABC₂ in einem ein- oder mehrphasigen sequenziellen Koverdampfungsprozess, bei dem die zeitlichen Längen der einzelnen Depositionsphasen (Phase I, Phase II, Phase III) im Schichtenwachstum durch charakteristische Wechsel in der stöchiometrischen Schichtzusammensetzung zwischen reicher und armer Element-A-Beteiligung bestimmt werden, mit einer kontinuierlichen Beschichtung eines bewegten Substrates (S) entlang einer Depositionsstrecke (DD) und mit einer optischen in-situ-Prozesskontrolle, bei der
• während der Schichtherstellung zyklisch ein kohärenter Lichtstrahl (LLS) über den Depositionsbereich (DA) des bewegten Substrats (S) mit einer Abtastgeschwindigkeit, die deutlich größer als die Fortschrittsgeschwindigkeit des Substrats (S) ist, geführt wird,
• das diffus an der aktuellen Schichtoberfläche rückgestreute Licht als Funktion des Ortes (tgΘ·h) auf dem bewegten Substrat (S) gemessen und als örtliches Streulichtprofil entlang der Depositionsstrecke (DD) für das Zeitintervall Δt, in dem der kohärente Lichtstrahl (LLS) einmal den Depositionsbereich (DA) des Substrats (S) abtastet, dargestellt wird,
• markante Punkte (1, 2, 3) im örtlichen Streulichtprofil den charakteristischen Wechseln (Punkte 1, 2, 3) in der stöchiometrischen Schichtzusammensetzung zugeordnet werden,
• die gemessenen markanten Punkte (1, 2, 2a, 3, 4) im aktuellen Streulichtprofil mit den entsprechenden Punkten in einem für die Herstellung vorgegebenen Referenz-Streulichtprofil verglichen werden und
• bei Auftreten einer örtlichen Abweichung der einander entsprechenden Punkte (1, 2, 2a, 3, 4) diese durch Änderung der Abscheiderate oder Fortschrittsgeschwindigkeit des bewegten Substrats (S) in der Prozessführung ausgeregelt wird.

2. Verfahren nach Anspruch 1 zur Herstellung einer Chalkopyrit-Dünnschicht des Elementtyps A^{I}(B^{III}B2^{III})C₂^{VI}, wobei das Element A^{I} der ersten Hauptgruppe, die Elemente B1^{III} und B2^{III} der dritten und das Element C^{VI} der sechsten Hauptgruppe der Elemente angehört.

3. Verfahren nach Anspruch 2 mit Cu, Ag, Al oder AgAl.Verbindungen als Element A', mit In oder Ga als Elemente B1^{III} und B2^{III} und mit Se, S oder SeS-Verbindungen als Element C^{IV}.

4. Verfahren nach Anspruch 2 oder 3 mit einem dreiphasigen, sequenziellen Koverdampfungsprozess, bei dem
• in Depositionsphase I bis zu einem markanten Punkt 1 durch Koverdampfung der Elemente B1^{III} B2^{III} und C^{VI} eine Vorläuferschicht gebildet wird,
• in Depositionsphase II bis zu den markanten Punkt 2 bzw. 2a mit einer erhöhten Substrattemperatur die Vorläuferschicht unter Verdampfung der Elemente A' und C^{VI} in eine Chalkopyritstruktur überführt wird, wobei bei dem markanten Punkt 2 das stöchiometrische Verhältnis Q = A^{I}/(B1^{III}=B2^{III}) zwischen den Elementen A^{I} und B1^{III}+B2^{III} gleich 1 ist (Q = 1) und bei dem markanten Punkt 2a oberhalb von 1 und unterhalb 1,3 liegt (1 < Q < 1,3), und
• in Depositionsphase III die gebildete Chalkopyrit-Dünnschicht unter Verdampfung der Elemente B1^{III}, B2^{III} und C^{VI} über einen markanten Punkt 3 mit dem stöchiometrischen Verhältnis Q = 1 bis zu einem das Verdampfungsende der Elemente B1^{III} und B2^{III} markierenden Punkt 4 mit einem optimalen stöchiometrischen Verhältnis Q ≈< 1 entsprechend einer leicht Element-A^{I}- armen Zusammensetzung fertigprozessiert wird, wobei der Prozess durch das Verdampfungsende des Elements C^{VI} abgeschlossen wird.

5. Verfahren nach einem der Ansprüche 1 bis 4 mit einer flexiblen Metallfolie oder einer temperaturbeständigen Kunststofffolie als Substrat (S).

6. Verfahren nach einem der Ansprüche 1 bis 5 mit einer Zugabe von katalytisch wirksamem Na.

7. Vorrichtung zur Durchführung eines Verfahrens zur Herstellung einer Chalkogenid-Halbleiterschicht des Elementtyps ABC₂ in einem ein- oder mehrphasigen sequenziellen Koverdampfungsprozess, bei dem die zeitlichen Längen der einzelnen Depositionsphasen (Phase I, Phase II, Phase III) im Schichtenwachstum durch charakteristische Wechsel (1, 2a) in der stöchiometrischen Schichtzusammensetzung zwischen reicher und armer Element-A-Beteiligung bestimmt werden, mit einer kontinuierlichen Beschichtung eines bewegten Substrates (S) entlang einer Depositionsstrecke (DD) und mit einer optischen in-situ-Prozesskontrolle mittels Messung von an der Chalkogenid-Halbleiterschicht rückgestreutem kohärentem Licht (LLS), insbesondere nach einem der Ansprüche 1 bis 6, mit zumindest einer Abscheidekammer (DC) mit einem kontinuierlich entlang der Depositionsstrecke (DD) fortbewegbaren Substrathalter (ST), dessen Rückseite von einem Substratheizer (SH) erwärmt wird, mit zumindest einer intermittierend (Q_{A}, Q_{B}) und einer dauerhaft (Q_{C}) betreibbaren Verdampferquelle und mit einer außerhalb der Abscheidekammer (DC) angeordneten optischen Prozesskontrolle mit einer kohärenten Lichtquelle (LS), deren emittierter Lichtstrahl (LLS) zyklisch und kontinuierlich mit einer Abtastgeschwindigkeit, die deutlich größer als die Fortschrittsgeschwindigkeit des Substrathalters (ST) ist, über den Depositionsbereich (DA) führbar ist, und mit einem Detektor (D), der die Rückstreuwerte in Abhängigkeit vom Messort (tgΘ·h) innerhalb der Depositionsstrecke (DD) detektiert und einer Auswertungseinheit zuführt, die die detektierten Rückstreuwerte vorgegebenen Referenzwerten zuordnet und für eine Ausregelung von Regelabweichungen durch Veränderung von Prozessparametern sorgt.

8. Vorrichtung nach Anspruch 7 mit einer vertikal kontinuierlichen verschiebbaren kohärenten Lichtquelle (LS), deren emittierter Lichtstrahl (LLS) auf einen Hohlspiegel (M) fällt, der rechtwinklig zu der vertikalen Verschiebungsachse angeordnet ist und den Lichtstrahl (LLS) in Abhängigkeit von der Vertikalposition der kohärenten Lichtquelle (LS) an unterschiedliche Stellen in den Depositionsbereich (DA) auf dem Substrat (S) lenkt.

9. Vorrichtung nach Anspruch 7 oder 8 mit drei Prozesskammern (DC_{I}, DC_{II}, DC_{III}) mit jeweils einer eigenen optischen Prozesskontrolle mit kohärenter Lichtquelle (LS_{I}, LS_{II},LS_{III}) und Detektor (D_{I}, D_{II}, D_{III}).

10. Vorrichtung nach einem der Ansprüche 7 bis 9 mit den Parametern
• Länge der Depositionsstrecke (DD) für Depositionsphase I 0,5 m
• Länge der Depositionsstrecke (DD) für Depositionsphase II 0,5 m
• Länge der Depositionsstrecke (DD) für Depositionsphase III 0,125 m
• Fortschrittsgeschwindigkeit des Substrats (S) 0,025 m/min
• Abtastgeschwindigkeit der kohärenten Lichtquelle (LS) 1.25 m/min
• Ortsauflösung 0,01 m
• Integrationszeit pro Messpunkt 0,48 s
• Substratdurchsatz 1,5 m/h

## Claims

1. Method for the production of a chalcogenide semiconductor layer of the element type ABC₂ in a single-phase or multiphase sequential co-evaporation process, where the duration of the individual deposition phases (phase I, phase II, phase III) in the layer growth is determined by characteristic changes in the stoichiometric layer composition between layers rich and deficient in element A, with continuous coating of a moving substrate (S) along a deposition distance (DD) and with an optical in-situ process control where:
• as the layer is being produced, a coherent light beam (LLS) is cyclically moved across the deposition area (DA) of the moving substrate (S) with a scanning rate which is significantly higher than the speed of progression of the substrate (S);
• the light diffusely backscattered from the layer surface at any one time is measured as a function of the location (tgΘ·h) on the moving substrate (S) and represented as a local scattered light profile along the deposition distance (DD) for the time interval Δt in which the coherent light beam (LLS) scans the deposition area (DA) of the substrate (S) once;
• distinctive points (1, 2, 3) in the local scattered light profile are assigned to the characteristic changes (points 1, 2, 3) in the stoichiometric layer composition;
• the distinctive points (1, 2, 2a, 3, 4) measured in the scattered light profile at any one time are compared to the corresponding points in a reference scattered light profile specified for the manufacture; and
• if the corresponding points (1, 2, 2a, 3, 4) deviate locally, this is corrected in the process control by changing the deposition rate or the speed of progression of the moving substrate (S).

2. The method according to Claim 1 for the production of a chalcopyrite thin layer of the element type A^{I}(B1 ^{III}B2^{III})C₂^{VI}, where the element A^{I} belongs to the first main group, the elements B1^{III} and B2^{III} to the third and the element C^{VI}, to the sixth main group of the elements.

3. The method according to Claim 2 with Cu, Ag, Al or AgAl compounds as element A^{I}, with In or Ga as elements 81^{III} and B2^{III} and with Se, S or SeS compounds as element C^{VI}.

4. The method according to Claim 2 or 3 with a triple-phase sequential co-evaporation process where:
• in deposition phase I, a precursor layer is formed by co-evaporation of the elements B1^{III}, B2^{III} and C^{VI} up to a distinctive point 1;
• in deposition phase II, the precursor layer is transformed into a chalcopyrite structure by evaporating elements A^{I} and C^{VI} up to the distinctive points 2 or 2a with an increased substrate temperature, where at the distinctive point 2, the stoichiometric ratio Q = A^{I}/(B1^{III} +B2^{III}) of the elements A^{I} and B1^{III}+B2^{III} is equal to 1 (Q = 1) and at the distinctive point 2a it is between 1 and 1.3 (1 < Q < 1.3); and
• in deposition phase III, the chalcopyrite thin layer formed is processed to completion by evaporating the elements B1^{III}, 82^{III} and C^{VI} at a distinctive point 3 with the stoichiometric ratio Q = 1 up to a point 4, which marks the completion of the evaporation of the elements B1^{III} and B2^{III}, with an optimum stoichiometric ratio Q ≈< 1 corresponding to a composition which is slightly deficient in element A^{I}, the process being concluded when the evaporation of the element C^{VI} is complete.

5. The method according to one of the Claims 1 to 4 with a flexible metal foil or a heat-resistant plastic film as the substrate (S).

6. The method according to one of the Claims 1 to 5 with catalytic Na being added.

7. Device to carry out a method for producing a chalcogenide semi-conductor layer of the element type ABC₂ in a single-phase or multiphase sequential co-evaporation process, where the duration of the individual deposition phases (phase I, phase II, phase III) in the layer growth is determined by the characteristic changes (1, 2a) in the stoichiometric layer composition with layers rich and deficient in element A, with continuous coating of a moving substrate (S) along a deposition distance (DD) and with an optical in-situ process control carried out by measuring the coherent light (LLS) backscattered by the chalcogenide semiconductor layer, particularly according to one of the Claims 1 to 6, with at least one deposition chamber (DC) with a substrate carrier (ST) which can be moved continuously along the deposition distance (DD), the rear of which is heated by a substrate heater (SH), with at least one evaporation source which can be operated intermittently (Q_{A}, Q_{B}) and one which can be operated permanently (Q_{C}), and with an optical process control which is located outside the deposition chamber (DC) with a coherent light source (LS), the emitted light beam (LLS) of which can be moved cyclically and continuously with a scanning rate which is significantly higher than the speed of progression of the substrate carrier (ST) over the deposition area (DA), and with a detector (D), which detects the backscatter values as a function of the measurement location (tgΘ·h) within the deposition distance (DD) and sends it to an evaluation unit, which assigns the backscatter values detected to specified reference values and controls the deviations from the specification by changing process parameters.

8. The device according to Claim 7 with a coherent light source (LS) which is continuously movable in the vertical direction and the emitted light beam (LLS) of which falls onto a concave mirror (M), which is arranged at right angles to the vertical displacement axis and which directs the light beam (LLS) to different positions in the deposition area (DA) on the substrate (S) depending on the vertical position of the coherent light source (LS).

9. The device according to Claim 7 or 8 with three processing chambers (DC_{I}, DC_{II}, DC_{III}) each having its own optical process control with coherent light source (LS_{I}, Ls_{II},L_{III}) and detector (D_{I}, D_{II}, D_{III}*).*

10. The device according to one of the Claims 7 to 9 with the parameters
• Length of the deposition distance (DD) for deposition phase I 0.5 m
• Length of the deposition distance (DD) for deposition phase II 0.5 m
• Length of the deposition distance (DD) for deposition phase III 0.125 m
• Speed of progression of the substrate (S) 0.025 m/min
• Scanning speed of the coherent light source (LS) 1.25 m/min
• Spatial resolution 0.01 m
• Integration time per measuring point 0.48 s
• Substrate throughput 1.5 m/h

## Revendications

1. Procédé de fabrication d'une couche semi-conductrice en chalcogénure de types d'éléments ABC₂ par un processus séquentiel de co-vaporisation à une ou plusieurs phases, selon lequel on détermine les durées des différentes phases de dépôt (phase I, phase II, phase III) dans la croissance de la couche par une alternance caractéristique de la composition stoechiométrique de la couche, entre une participation riche et une participation pauvre de l'élément A, par un revêtement continu d'un substrat (S) en mouvement le long d'un trajet de dépôt (DD) et par un contrôle optique in situ du procédé, selon lequel
- au cours de la fabrication de la couche, on applique de manière cyclique un faisceau de lumière cohérente (LLS) sur la zone de dépôt (DA) du substrat en mouvement (S) à une vitesse de détection significativement plus grande que la vitesse de progression du substrat (S),
- on mesure la lumière renvoyée de façon diffuse à la surface actuelle de la couche, en fonction du lieu (tgθ · h) sur le substrat en mouvement (S) et on représente comme profil de lumière diffuse, locale, le long du trajet de dépôt (DD) pendant l'intervalle de temps Δt selon lequel le faisceau de lumière cohérente (LLS) détecte une fois la zone de dépôt (DA) du substrat (S),
- on associe les points marquants (1, 2, 3) du profil local de lumière diffusée aux alternances caractéristiques (points 1, 2, 3) de la composition stoechiométrique de la couche,
- on compare les points marquants mesurés (1, 2, 2a, 3, 4) du profil actuel de lumière diffusée aux points correspondant à un profil de lumière diffusée de référence, prédéfini pour la fabrication, et
- en cas d'écart local des points correspondants (1,2, 2a, 3, 4) on compense par variation de la vitesse de dépôt ou la vitesse de progression du substrat mobile (S) dans la conduite du procédé.

2. Procédé selon la revendication 1,
pour la fabrication d'une couche mince en chalcopyrite du type d'éléments A^{I}(B1^{III}B2^{III})C2^{VI}, selon lequel l'élément A^{I} appartient au premier groupe principal, les éléments B1^{III} et B2^{III} appartiennent au troisième groupe principal des éléments et l'élément C^{VI} appartient au sixième groupe principal des éléments.

3. Procédé selon la revendication 2,
avec comme élément A^{I}, Cu, Ag, Al ou des combinaisons AgAl, avec In ou Ga comme éléments B1^{III} et B2^{III} et avec Se, S ou des combinaisons SeS comme élément C^{IV}.

4. Procédé selon la revendication 2 ou 3,
avec un processus de co-dépôt à la vapeur, séquentiel, à trois phases, selon lequel
- dans la phase de dépôt I et jusqu'à un point marquant 1, par co-dépôt à la vapeur des éléments B1^{II}I, B2^{III} et C^{VI} on forme une couche préalable,
- dans la phase de dépôt II jusqu'aux points marquants 2 et 2a, avec une élévation de la température du substrat, on transforme la couche préalable par évaporation des éléments A^{I} et C^{VI} en une structure de chalcopyrite, et au point marquant 2, le rapport stoechiométrique Q = A^{I}/(B1^{III}+B2^{III}) entre les éléments A^{I} et B1^{III} + B2^{III} est égal à 1 (Q =1) et pour le point marquant 2a, ce rapport est supérieur à 1 ou inférieur à 3 (1 < Q < 1, 3), et
- dans la phase de dépôt III on termine le traitement de la couche mince de chalcopyrite sous évaporation des élément B1^{III,} B2^{III} et C^{VI} au-delà du point marquant 3 avec le rapport stoechiométrique Q =1 jusqu'à un point P4 marquant la fin de la vaporisation des éléments B1^{III} et B2^{III}, avec un rapport stoechiométrique optimum Q ≈< 1 correspondant à une composition légèrement appauvrie en élément A^{I}, le procédé se terminant par la fin de l'évaporation de l'élément C^{VI}.

5. Procédé selon l'une des revendications 1 à 4,
appliqué à un film métallique souple ou à un film de matière plastique résistant à la température et constituant le substrat (S).

6. Procédé selon l'une des revendications 1 à 5,
avec addition de Na à effet catalytique.

7. Dispositif pour la mise en oeuvre du procédé de fabrication d'une couche semi-conductrice de chalcogénure du type d'éléments ABC₂ par un processus de co-dépôt à la vapeur, séquentiel, à une ou plusieurs phases, selon lequel on détermine la durée des différentes phases de dépôt (phase I, phase II, phase III) dans la croissance de la couche par alternance caractéristique (1, 2a) de la composition stoechiométrique de la couche entre une participation plus riche et plus pauvre de l'élément A, avec revêtement continu d'un substrat (S) en mouvement le long d'un trajet de dépôt (DD) et avec un contrôle optique in situ du procédé par la mesure de la lumière cohérente (LLS) renvoyée par la couche semi-conductrice de calchogénure, notamment selon l'une des revendications 1 à 6 avec au moins une chambre de dépôt (DC) et un support de substrat (ST) déplacé en continu le long du trajet de dépôt (DD), et dont le côté arrière est chauffé par un dispositif de chauffage de substrat (SH), avec au moins une source de vaporisation fonctionnant de manière intermittente (Q_{A}, Q_{B}) et de manière permanente (Q_{C}) et avec un contrôle optique de procédé à l'extérieur de la chambre de dépôt (DC) par une source de lumière cohérente (LS) dont le faisceau lumineux émis (LLS) est conduit de manière cyclique et continue à une vitesse de détection significativement supérieure à la vitesse de progression du support de substrat (ST) sur la zone de dépôt (DA) et avec un détecteur (D) qui détecte les valeurs de diffusion en fonction de l'emplacement de la mesure (tgθ · h) sur le trajet de dépôt (DD) et fournit le signal à une unité d'exploitation qui associe les valeurs de diffusion détectées à des valeurs de référence prédéfinies et assure la compensation par régulation des écarts de régulation par modification des paramètres du procédé.

8. Dispositif selon la revendication 7,
comportant une source de lumière cohérente (LS) coulissant en continu dans la direction verticale et dont le faisceau de lumière émise (LLS) arrive sur un miroir creux (M) installé perpendiculairement à l'axe de coulissement vertical et qui dirige le faisceau lumineux (LLS) en fonction de la position verticale de la source de lumière cohérente (LS) vers des endroits différents de la zone de dépôt (DA) sur le substrat (S).

9. Dispositif selon la revendication 7 ou 8,
comportant trois chambres de procédé (DC_{I}, DC_{II}, DC_{III}), avec chaque fois son propre contrôle optique de processus par une source de lumière cohérente (LS_{I}, LS_{II}, LS_{III}) et un détecteur (D_{I}, D_{II}, D_{III})·

10. Dispositif selon l'une des revendications 7 à 9,
avec les paramètres suivants :
- longueur du trajet de dépôt (DD) pour la phase de dépôt I 0,5 m
- longueur du trajet de dépôt (DD) pour la phase de dépôt II 0,5 m
- longueur du trajet de dépôt (DD) pour la phase de dépôt III 0,125 m
- vitesse de progression du substrat (S) 0,025 m/min
- vitesse de détection de la source de lumière cohérente (LS) 1,25 m/min
- résolution du lieu 0,01 m
- temps d'intégration par point de mesure 0,48 s
- débit du substrat 1,5 m/h
